# EUROPÄISCHE PATENTANMELDUNG

(11) **EP 1 160 854 A1**
(43) Veröffentlichungstag der Anmeldung: **05.12.2001**
(21) Anmeldenummer: 01110675.4
(22) Anmeldetag: 02.05.2001
(51) Int. Cl.: H01L 21/68

(54) **Verfahren zur rückseitigen elektrischen Kontaktierung eines Halbleitersubstrats während seiner Bearbeitung**

(30) Priorität: 31.05.2000 DE 10027931
(71) Anmelder: Infineon Technologies AG, 81669 München (DE)
(72) Erfinder: Birner, Albert, Dr., 01129 Dresden (DE); Franosch, Martin, 81739 München (DE); Goldbach, Matthias, Dr., 01099 Dresden (DE); Lehmann, Volker, Dr., 80689 München (DE); Luetzen, Joern, Dr., 01099 Dresden (DE)
(74) Vertreter: Epping Hermann & Fischer

(57) **Zusammenfassung**

Die vorliegende Erfindung betrifft ein Verfahren zur Kontaktierung einer Rückseite (9) eines Halbleitersubstrats (1), wobei die Rückseite (9) zumindest teilweise von einer isolierenden Schicht freigelegt wird, und das Substrat (1) mit seiner Rückseite (9) auf einer leitfähigen Kontaktschicht (3) angeordnet wird, die ihrerseits auf einem Substrathalter (2) angeordnet wird.

## Beschreibung

Die vorliegende Erfindung betrifft ein Verfahren zur rückseitigen elektrischen Kontaktierung eines Halbleitersubstrats während seiner Bearbeitung.

Bei der Herstellung von Halbleiterbauelementen werden Verfahrensschritte verwendet, die eine elektrische Kontaktierung zu dem zu bearbeitenden Substrat erfordern. Dies ist z.B. bei elektrischen bzw. elektrochemischen Prozeßschritten der Fall. Um sehr viele gleichartige Bauelemente parallel auf einem Halbleitersubstrat herstellen zu können ist es erforderlich, daß das Substrat durch den Prozeßschritt gleichmäßig bearbeitet wird. Dies erfordert Kontaktierungsverfahren die einen bezüglich des Substrats möglichst homogenen elektrischen Kontakt herstellen. Ist kein homogener elektrischer Kontakt gewährleistet, so ergibt sich eine Variation des elektrischen Potentials über dem Substrat, was sich in einer inhomogenen Prozeßführung bemerkbar machen kann und eine gleichmäßige Durchführung des Prozeßschrittes verhindert. Die Schwankung führt zu einer ungleichmäßigen galvanischen Abscheidung (bei negativem Substratpotential) und einer ungleichmäßigen anodischen Auflösung (bei positivem Substratpotential).

Bei der anodischen Auflösung des Substrats bilden sich z.B. bei geeignet gewählter Dotierung und Elektrolytzusammensetzung bei einem niedrigen anodischen Potential Poren aus und bei einem hohen anodischen Potential elektropolierte Flächen. Dies stellt eine gravierende Abhängigkeit der zu bildenden Halbleiterbauelemente von dem anliegenden Potential dar und kann die Bildung funktionierender Halbleiterbauelemente verhindern.

Die Bildung von Poren in Silizium ist z.B. für die Herstellung von Grabenkondensatoren interessant, da durch die Porenbildung eine erhebliche Oberflächenvergrößerung und eine damit verbundene Kapazitätsvergrößerung realisiert werden kann. Als Poren sind sogenannte Mesoporen mit einem Porendurchmesser im Bereich von 2-10 Nanometern (nm) besonders geeignet. Da - wie bereits oben erwähnt - die Bildung von Poren von dem elektrischen Potential abhängt, ist es von großer Wichtigkeit dieses Potential möglichst gleichmäßig über das Substrat anzulegen.

Die Patentanmeldung DE 197 28 962 A1 beschreibt beispielsweise eine Vorrichtung zum Ätzen einer Halbleiterscheibe. Die Vorrichtung ist beispielsweise dazu geeignet, eine Hauptfläche der Halbleiterscheibe zu ätzen. Die Halbleiterscheibe wird von der Rückseite her in ihrem Randbereich elektrisch kontaktiert.

Die Druckschrift JP 59-41830 A betrifft eine Halterung eines Halbleitersubstrats, mittels der eine Flüssigkeit zum Elektroplattieren des Halbleitersubstrats gegen das Halbleitersubstrat gesprüht wird. Auch hier erfolgt die elektrische Kontaktierung im rückseitigen Randbereich.

Die Druckschrift US 4,428,815 betrifft eine Vakuum-Haltevorrichtung zum Halten zerbrechlicher Gegenstände wie beispielsweise Halbleitersubstraten. Die elektrische Kontaktierung erfolgt mittels rückseitiger Kontaktelemente im Substratzentrum.

Die Druckschrift US 5,437,777 betrifft eine Anlage zum Abscheiden einer Verdrahtungsebene auf einen Halbleiterwafer. Um einen elektrischen Kontakt mit der Substratvorderseite zu erreichen, werden Nadelelektroden auf die Vorderseite des Substrats aufgesetzt.

Die Druckschrift JP 10-046394A betrifft eine Anlage zum Elektroplattieren. Dabei handelt es sich um ein galvanisches Verfahren zur Abscheidung einer beispielsweise metallischen Schicht. Hierbei ist eine Haltevorrichtung für den Halbleiterwafer so ausgeführt, daß der Halbleiterwafer an seinem Umfang kontaktiert wird.

In Druckschrift JP 62-293632 A wird eine mit Löchern versehene isolierende Schicht vorgeschlagen, die zwischen einem Halbleiterwafer und einem Chuck angeordnet wird.

Die Druckschrift JP 11-181600 A betrifft ein Verfahren zur Überprüfung des elektrischen Kontakts von Anschlußpins einer Elektroplattierungs-Vorrichtung. Die Anschlußpins sind mit einem leitfähigen Film verbunden, der auf dem Wafer angeordnet ist. Um den elektrischen Kontakt eines Anschlußpins zu überprüfen wird der elektrische Widerstand dieses Anschlußpins zu den anderen Anschlußpins bestimmt.

Ein bekanntes Verfahren, einen gleichmäßigen ganzflächigen rückseitigen Kontakt herzustellen, ist z.B. in dem Patent US 5,209,833 gezeigt. Es wird ein Elektrolytkontakt zu der Substratrückseite hergestellt, der eine sehr geringe Schwankung des Kontaktwiderstands zwischen Substrat und Elektrolyt gewährleistet.

Das Verfahren des ganzflächigen Elektrolytrückseitenkontakts ist allerdings prozesstechnisch aufwendig, da der Elektrolyt stets eine Naßzelle erfordert.

Es ist die Aufgabe der vorliegenden Erfindung ein Verfahren zur gleichmäßigen Kontaktierung eines Halbleitersubstrats anzugeben.

Die erfindungsgemäße Aufgabe wird gelöst durch ein Verfahren zur rückseitigen elektrischen Kontaktierung eines Halbleitersubstrats während seiner Bearbeitung, wobei
- ein Substrat, das eine Substratrückseite und eine ihr gegenüberliegende Substratvorderseite aufweist, von einer auf der Substratrückseite angeordneten isolierenden Schicht freigelegt wird und
- das Substrat mit seiner Substratrückseite auf einem Substrathalter angeordnet wird, wobei
- zwischen dem Substrat und dem Substrathalter eine elektrisch leitfähige Kontaktschicht aus einem Halbleitermaterial angeordnet wird.

Der Vorteil des erfindungsgemäßen Verfahrens besteht darin, daß auf einen Elektrolytkontakt verzichtet werden kann, der eine aufwendige Naßzelle erfordern würde. Statt dessen wird die elektrische Verbindung erfindungsgemäß durch eine elektrisch leitfähige Kontaktschicht hergestellt, die in Kombination mit einem Substrathalter verwendet werden kann, bei dem es sich beispielsweise um einen metallischen bzw. metallbeschichteten Vakuum-Chuck handelt. Dabei wird beispielsweise die leitfähige Kontaktschicht zuerst auf dem Chuck angeordnet und anschließend das Substrat auf der leitfähigen Kontaktschicht angeordnet.

Der elektrische Kontakt dient beispielsweise bei elektrischen bzw. elektrochemischen Prozessen dazu, einen gleichmäßigen Stromfluß von der Substratvorderseite zu dem Substrathalter zu ermöglichen.

In einer Ausgestaltung der Erfindung ist vorgesehen, daß die leitfähige Kontaktschicht als eine Diffusionsbarriere für Materialien gebildet wird, aus denen der Substrathalter besteht. Ohne Diffusionsbarriere könnte ein mit einer Goldschicht versehener Vakuum-Chuck ein aus Silizium bestehendes Halbleitersubstrat verunreinigen, wobei die Goldatome Störstellen in dem Siliziumsubstrat bilden, wodurch die Funktionen eines Feldeffekttransistors gestört werden kann.

Eine weitere Ausgestaltung der Erfindung sieht vor, daß die leitende Kontaktschicht aus einem Halbleitermaterial gebildet wird. Die Verwendung eines Halbleitermaterials bzw. vorzugsweise die Verwendung desselben Halbleitermaterials wie das Substrat kann die Kontamination des Substrats in geeigneter Weise verhindern.

Weiterhin ist vorgesehen, daß die leitfähige Kontaktschicht mit dem gleichen Ladungsträgertyp dotiert wird, wie das Substrat. Durch die Verwendung des gleichen Ladungsträgertyps wird in vorteilhafter Weise ein pn-Übergang vermieden, der bei einer Stromflußrichtung eine Dioden-Sperrwirkung aufweist. Durch die Verwendung des gleichen Ladungsträgertyps wird ein niederohmiger elektrischer Kontakt zwischen dem Substrat und der leitfähigen Schicht ermöglicht. Um einen niedrigen Widerstand in der leitfähigen Kontaktschicht zu erreichen wird die leitfähige Kontaktschicht mit einer hohen Dotierstoffkonzentration versehen. Da das Substrat üblicherweise an seiner Rückseite eher schwach dotiert ist, wird durch die hohe Dotierung der leitfähigen Kontaktschicht eine homogene Stromverteilung auf der Substratrückseite erreicht.

In einer Weiterbildung der Erfindung ist vorgesehen, daß in der leitfähigen Kontaktschicht in einer dem Substrat zugewandten Oberfläche ein Graben gebildet wird. Die Bildung eines Grabens in einer der Substratrückseite zugewandten Oberfläche der leitenden Kontaktschicht ermöglicht es, durch ein in dem Graben befindliches Vakuum die Substratrückseite und damit das Substrat an die leitfähige Kontaktschicht anzupressen. Durch das Anpressen des Substrats an die leitfähige Kontaktschicht wird ein niederohmiger Kontakt zwischen der leitfähigen Kontaktschicht und dem Substrat ermöglicht.

Eine Ausgestaltung der Erfindung bildet in der leitfähigen Kontaktschicht in einer dem Substrat zugewandten Oberfläche eine Mesa. Bei einer Mesa handelt es sich im Gegensatz zu einem Graben um eine von einem Graben umgebene Struktur, die als Erhebung ihre Umgebung überragt. Die Mesa ist z.B. dazu geeignet, daß die Substratrückseite an die Mesa angepreßt wird und so einen niederohmigen elektrischen Kontakt zwischen der Substratrückseite und der Mesa ermöglicht. Dies kann durch ein Vakuum erreicht werden, das in einem Graben angeordnet ist, der die Mesa umgibt.

Die auf der dem Substrat zugewandten Oberfläche der leitfähigen Kontaktschicht angeordneten Gräben und Mesa dienen dazu, eine gleichmäßige Verteilung des Anpreßdrucks des Substrats an die leitfähige Kontaktschicht durch eine geeignete Anordnung von Gräben und Mesa zu ermöglichen. Beispielsweise ist hier ein schachbrettartiges Muster von Gräben und/oder Mesa dazu geeignet, auf der gesamten Substratrückseite eine gleichmäßige Verteilung von Vakuum und elektrischen Kontakten zu ermöglichen, die durch die Mesa bereit gestellt werden.

Weiterhin ist vorgesehen, daß in der leitfähigen Kontaktschicht ein Loch gebildet wird, das sich von einer dem Substrat zugewandten Oberfläche bis zu einer dem Substrathalter zugewandten Oberfläche der leitenden Kontaktschicht erstreckt. Die Anordnung eines Lochs, das sich durch die leitfähige Kontaktschicht erstreckt, ermöglicht es in vorteilhafter Weise die Vakuumvorrichtung des Vakuum-Chucks zu verwenden, um das Substrat an die leitfähige Kontaktschicht anzupressen. Dies ist besonders vorteilhaft, da Vakuum-Chucks bereits mit einem Vakuumanschluß sowie Vakuumlöchern in der dem Substrat zugewandten Oberfläche des Vakuum-Chucks ausgestattet sind. Hierdurch wird die Notwendigkeit einer separaten Vakuumvorrichtung für die leitfähige Kontaktschicht vermieden.

Es ist weiterhin von Vorteil, wenn in der leitfähigen Kontaktschicht in einer dem Substratträger zugewandten Oberfläche ein zweiter Graben gebildet wird. Wie oben beschrieben dient der erste Graben dazu, das Substrat an die leitfähige Kontaktschicht mittels Vakuum anzupressen. Der zweite Graben dient nun dazu, das Vakuum das von den Vakuumlöchern in der Oberfläche des Substratträgers durch die leitfähige Kontaktschicht hindurch zu leiten.

Weiterhin ist es vorteilhaft, in der leitfähigen Kontaktschicht in einer dem Substratträger zugewandten Oberfläche eine zweite Mesa zu bilden. Ein Muster zu dem der zweite Graben und die zweite Mesa gehören, ist z.B. dazu geeignet, daß die leitfähige Kontaktschicht - ohne Feinjustierung auf die von dem Substratträger bereitgestellten Vakuumöffnungen - auf den Substratträger aufgelegt werden kann. Mittels des zweiten Grabens und des Lochs wird das Vakuum von dem Substratträger bis zu dem Substrat durch die leitende Kontaktschicht hindurchtransportiert.

In einem weiteren Verfahrensschritt ist vorgesehen, daß in dem Graben ein geringerer Druck erzeugt wird, als an der Substratvorderseite. Durch die Druckdifferenz zwischen Substratvorderseite und Graben wird das Substrat an die leitfähige Kontaktschicht und damit die leitfähige Kontaktschicht an den Substrathalter angepreßt.

Weitere Ausgestaltungen der Erfindung sind Gegenstand der jeweiligen abhängigen Ansprüche.

Nachfolgend wird die Erfindung anhand von Figuren und einem Ausführungsbeispiel näher erläutert.

In den Figuren zeigen:
- Figur 1: eine schematische Zeichnung einer elektrochemischen Prozeßkammer mit einem Substrathalter, einer leitfähigen Kontaktschicht und einem Substrat;
- Figur 2: eine vergrößerte Darstellung des Substrathalters, der leitfähigen Kontaktschicht und des Substrats;

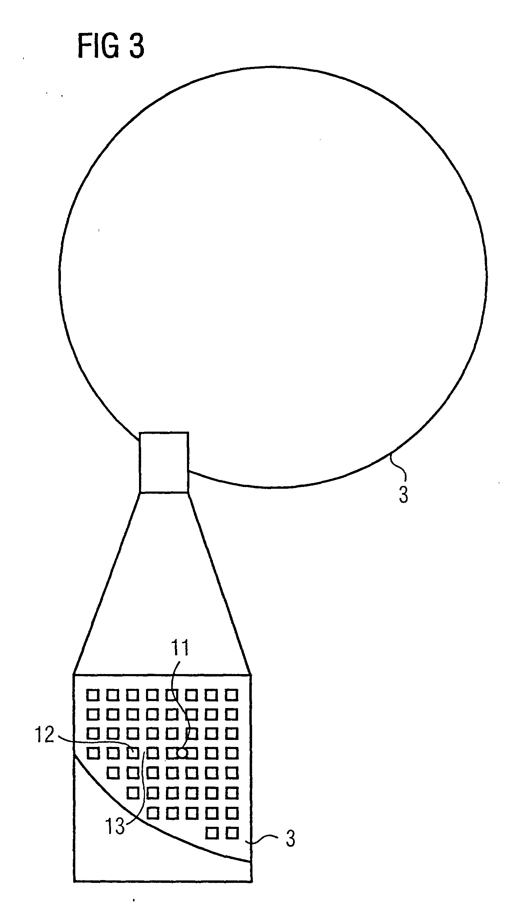

- Figur 3: eine leitfähige Kontaktschicht mit einer Anordnung von Gräben und Mesa.

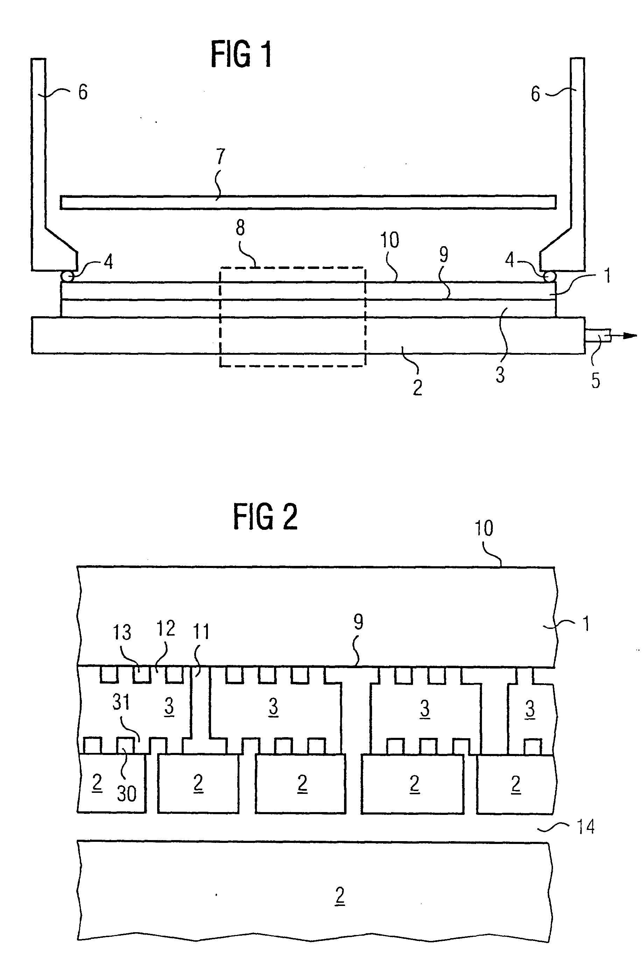

In Figur 1 ist ein Substrathalter 2 dargestellt. Dabei handelt es sich beispielsweise um einen Vakuum-Chuck. Der Substrathalter 2 weist einen Vakuumanschluß 5 zum Absaugen von Gasen auf. Auf den Substrathalter 2 ist eine Kontaktschicht 3 angeordnet. Die Kontaktschicht 3 ist beispielsweise aus einem leitfähigen Halbleitermaterial, wie hoch dotiertem Silizium bzw. Galliumarsenid, hergestellt. Auf der leitfähigen Kontaktschicht 3 ist ein Substrat 1 mit einer der leitfähigen Kontaktschicht 3 zugewandten Substratrückseite und einer der leitfähigen Kontaktschicht 3 abgewandten Substratvorderseite anordnet. Das Substrat 1 enthält beispielsweise Silizium. Auf dem Substrat 1 ist in diesem Ausführungsbeispiel ein Dichtungsring 4 auf dem Rand des Substrats 1 angeordnet. Auf dem Dichtungsring 4 ist ein Ätzbecher 6 angeordnet, der eine rohrartige Form aufweist. Der Ätzbecher 6 dient beispielsweise dazu ein Ätzmittel aufzunehmen, welches in diesem Fall die Substratoberfläche 10 benetzt. Weiterhin ist in dem Ätzbecher 6 eine Gegenelektrode 7 angeordnet. Die Gegenelektrode 7 ist beispielsweise ein Netz bzw. eine Platte, wobei die Ausbildung als Netz die Durchleitung von Licht erlaubt, und besteht beispielsweise aus Platin. Bei einem Prozeß in dem Ätzbecher 6 fließt beispielsweise ein Strom von der Gegenelektrode 7 durch das Ätzmittel zu der Substratvorderseite 10, durch das Substrat zu der Substratrückseite 9, an der der Strom in die leitfähige Kontaktschicht 3 tritt, durch die leitfähige Kontaktschicht 3 und zu dem Substrathalter 2. Um eine gleichmäßige Prozessierung der Substratvorderseite 10 zu erreichen, ist es von Vorteil, wenn der Strom mit einer gleichmäßigen Stromdichte senkrecht aus dem Ätzmittel in die Substratvorderseite 10 eintritt.

Die leitfähige Kontaktschicht 3 besteht dabei beispielsweise aus einem hoch dotierten Siliziumwafer. Der hoch dotierte Siliziumwafer hat den Vorteil, daß er auf beiden Seiten einen niederohmigen elektrischen Kontakt ermöglicht. Dadurch wird eine niederohmige elektrische Verbindung zwischen der Substratrückseite 9 und dem Substrathalter 2 erreicht. Der gestrichelt gezeichnete Bereich 8 ist in Figur 2 dargestellt und wird im Folgenden näher erläutert.

In Figur 2 ist der Bereich 8 aus Figur 1 dargestellt. Der Substrathalter 2 weist dabei eine Vakuumleitung 14 auf, die sich beispielsweise bis zu einer Oberfläche des Substrathalters 2 erstreckt. Auf dem Substrathalter 2 ist die leitfähige Kontaktschicht 3 angeordnet. Auf der leitfähigen Kontaktschicht 3 ist wiederum das Substrat 1 mit seiner Substratrückseite 9 angeordnet. Die leitfähige Kontaktschicht 3 ist in diesem Ausführungsbeispiel so ausgebildet, daß sie in der dem Substrat zugewandten Oberfläche einen Graben 13 und eine Mesa 12 aufweist. Weiterhin erstreckt sich durch die leitfähige Kontaktschicht 3 ein Loch 11, das von der dem Substrat 1 zugewandten bis zu der dem Substrathalter zugewandten Oberfläche reicht. In der dem Substrathalter 2 zugewandten Oberfläche ist ein zweiter Graben 30 sowie eine zweite Mesa 31 angeordnet. Die der Substratrückseite 9 zugewandte Mesa 12 und Graben 13 dienen dazu, das von dem Substrathalter 2 bereit gestellte Vakuum gleichmäßig über die Substratrückseite 9 zu verteilen, so daß eine gleichmäßige Anpressung des Substrats 1 an die leitfähige Kontaktschicht 3 erfolgt. Das Loch 11 dient dazu, das Vakuum von der Vakuumleitung 14 durch die leitfähige Kontaktschicht 3 zu leiten.

Für ein p-dotiertes Substrat 1 wird beispielsweise eine hoch p-dotierte leitfähige Kontaktschicht 3 aus Silizium auf den Substrathalter 2 aufgelegt. Falls das Substrat 1 n-dotiert ist, so wird die leitfähige Kontaktschicht 3 aus einem hoch n-dotierten Halbleitermaterial gebildet. Um den Substrathalter 2 variabel verwenden zu können, ist es vorgesehen, daß die leitfähige Kontaktschicht 3 lose auf den Substrathalter 2 aufgelegt wird, um die leitfähige Kontaktschicht 3 ggf. durch eine andere leitfähige Kontaktschicht 3 mit einem anderen Dotierstofftyp auszutauschen. In einem weiteren Ausführungsbeispiel ist es z.B. möglich, die leitfähige Kontaktschicht 3 durch ein CVD-Verfahren (Chemical Vapour Deposition) direkt auf dem Substrathalter 2 abzuscheiden und somit fest mit dem Substrathalter 2 zu verbinden.

Für den Fall, daß die leitfähige Kontaktschicht 3 lose auf dem Substrathalter 2 angeordnet ist, ist eine Justierung des Lochs 2 bezüglich der Vakuumleitung 14 erforderlich, um das Vakuum von dem Substrathalter 2 zu dem Substrat 1 zu leiten. Die zweite Mesa 31 und der zweite Graben 30 ermöglichen allerdings, auf einen Justierschritt zu verzichten, da bei einer beliebigen Positionierung der leitfähigen Kontaktschicht 3 stets gewährleistet ist, daß ein zweiter Graben 30 über einer Vakuumleitung 14 zu liegen kommt und somit das Vakuum durch den zweiten Graben 30 über das Loch 11 zu der Substratrückseite 9 transportiert.

Zur Herstellung der Mesastruktur auf beiden Seiten der leitfähigen Kontaktschicht 3 kann beispielsweise ein Lithographieschritt wie eine Stepperbelichtung bzw. eine Kontaktlithographie verwendet werden. Dabei wird beispielsweise eine Maskenschicht aus Siliziumoxid bzw. Siliziumnitrid gebildet und die Mesastruktur selbst durch Plasmaätzen oder durch ein naßchemisches Ätzen z.B. mit einer Lauge wie KOH oder NH₄OH hergestellt. Wird die Mesa 12 beispielsweise als quadratischer Kontaktstempel ausgebildet bzw. als Pyramidenstumpf gebildet, so können benachbarte Kontaktstempel in einem hexagonalen Raster angeordnet werden. Die einzelnen Kontaktstempel können beispielsweise 800*µ*m voneinander entfernt sein. Dabei weisen die einzelnen Kontaktstempel eine Kantenlänge im Bereich von 100 bis 400*µ*m auf. Durch Verringerung der Kantenlänge der Kontaktstempel kann der Anpreßdruck entsprechend erhöht werden. Werden die Kontaktstempel als Pyramidenstümpfe gebildet, so kann es dazu kommen, daß die Ätzung so weit fortschreitet, daß die Kontaktstempel als Pyramide mit einer Spitze gebildet werden. Durch die große Gitterkonstante des hexagonalen Musters und die kleine Auflagefläche der Pyramidenstümpfe bzw. der Kontaktspitzen der Pyramide ist es möglich, störende Einflüsse geringfügiger Unebenheiten des Substrats 1 wie sie z.B. durch Verbiegung, Partikel oder Rauhigkeit der Substratrückseite 9 auftreten, zu minimieren.

Beispielsweise ist es auch möglich, die leitfähige Kontaktschicht 3 durch Klemmen bzw. leitfähiges Kleben an dem Substrathalter 2 zu befestigen.

Je nach Dotierstoffkonzentration der Substratrückseite 9, die die Leitfähigkeit des Substrats 1 beeinflußt, kann es erforderlich sein, die Substratrückseite 9 durch einen zusätzlichen Implantationsschritt mit einer höheren Dotierstoffkonzentration zu versehen.

Wird beispielsweise der Substrathalter 2 mit einer hoch dotierten Polysiliziumschicht überzogen, so wird diese mit einer Dicke von einigen *µ*m gebildet. Anschließend kann in die Polysiliziumschicht eine Mesastruktur gemäß der oben angegebenen Schritte erzeugt werden.

Weiterhin ist es möglich, den Substrathalter 2 mit einer geeigneten Mesastruktur an seiner Oberfläche zu versehen und diese anschließend mit einer dünnen, hoch dotierten Polysiliziumschicht zu bedecken. Dadurch ist sichergestellt, daß die Mesastruktur des Substrathalters 2 an der dem Substrat zugewandten Oberfläche der leitfähigen Kontaktschicht 3 erhalten bleibt.

## Patentansprüche

1. Verfahren zur rückseitigen elektrischen Kontaktierung eines Halbleitersubstrats während seiner Bearbeitung, wobei
- ein Substrat (1), das eine Substratrückseite (9) und eine ihr gegenüber liegende Substratvorderseite (10) aufweist, von einer auf der Substratrückseite (9) angeordneten isolierenden Schicht freigelegt wird;
- das Substrat (1) mit seiner Substratrückseite (9) auf einem Substrathalter (2) angeordnet wird,
**dadurch gekennzeichnet, daß**
zwischen dem Substrat (1) und dem Substrathalter (2) eine elektrisch leitfähige Kontaktschicht (3) aus einem Halbleitermaterial angeordnet wird.

2. Verfahren nach Anspruch 1,
**dadurch gekennzeichnet, daß**
die leitfähige Kontaktschicht (3) als eine Diffusionsbarriere für Materialien gebildet wird, aus denen der Substrathalter (2) besteht.

3. Verfahren nach einem der Ansprüche 1 bis 2,
**dadurch gekennzeichnet, daß**
die leitfähige Kontaktschicht (3) mit dem gleichen Ladungsträgertyp dotiert wird wie das Substrat (1).

4. Verfahren nach einem der Ansprüche 1 bis 3,
**dadurch gekennzeichnet, daß**
in der leitfähigen Kontaktschicht (3) von einer dem Substrat (1) zugewandten Oberfläche her ein Graben (13) gebildet wird.

5. Verfahren nach einem der Ansprüche 1 bis 4,
**dadurch gekennzeichnet, daß**
in der leitfähigen Kontaktschicht (3) in einer dem Substrat (1) zugewandten Oberfläche eine Mesa (12) gebildet wird.

6. Verfahren nach einem der Ansprüche 1 bis 5,
**dadurch gekennzeichnet, daß**
in der leitfähigen Kontaktschicht ein Loch (11) gebildet wird, das sich von einer dem Substrat (1) zugewandten Oberfläche bis zu einer dem Substrathalter (2) zugewandten Oberfläche der leitfähigen Kontaktschicht (3) erstreckt.

7. Verfahren nach einem der Ansprüche 4 bis 6,
**dadurch gekennzeichnet, daß**
in der leitfähigen Kontaktschicht (3) in einer dem Substratträger (2) zugewandten Oberfläche ein zweiter Graben (30) gebildet wird.

8. Verfahren nach einem der Ansprüche 5 bis 7,
**dadurch gekennzeichnet, daß**
in der leitfähigen Kontaktschicht (3) in einer dem Substratträger (2) zugewandten Oberfläche eine zweite Mesa (31) gebildet wird.

9. Verfahren nach einem der Ansprüche 4 bis 8,
**dadurch gekennzeichnet, daß**
in dem Graben (13) ein geringerer Druck erzeugt wird als an der Substratvorderseite (10).
